# FASCICULE DE BREVET EUROPEEN

(11) **EP 2 180 511 B1**
(45) Date de publication et mention de la délivrance du brevet: **29.08.2018**
(21) Numéro de dépôt: 09173958.1
(22) Date de dépôt: 23.10.2009
(51) Int. Cl.: H01L 27/146, H01L 31/0232, H01L 31/0352, H01L 31/101, G01J 3/18, G01J 3/36, G01J 3/02

(54) **Dispositif d'imagerie multispectral à base de multi-puits quantiques**
Vorrichtung zur multispektralen Bildgebung auf der Grundlage von Mehrfachquantentöpfen
Multi-spectrum imaging device based on quantum multi-wells

(30) Priorité: 24.10.2008 FR 0805921
(43) Date de publication de la demande: 28.04.2010
(73) Titulaire: SOFRADIR, 92290 Châtenay Malabry (FR)
(72) Inventeur: Nedelcu, M. Alexandru, 92340 BOURG LA REINE (FR); Bois, Philippe, 77240, CESSON (FR); Costard, Eric, 91300 MASSY (FR)
(74) Mandataire: Cabinet Laurent & Charras

(56) Documents cités:
- EP-A- 1 174 927
- US-A1- 2004 108 564
- LEVINE B F: "QUANTUM-WELL INFRARED PHOTODETECTORS", JOURNAL OF APPLIED PHYSICS, AMERICAN INSTITUTE OF PHYSICS. NEW YORK, US, vol. 74, no. 8, 15 octobre 1993 (1993-10-15), pages R01-81, XP000400022, ISSN: 0021-8979

## Description

Le domaine de l'invention est celui des dispositifs d'imagerie thermique multispectraux et notamment ceux à structure à multi-puits quantiques, particulièrement adaptés au domaine infrarouge.

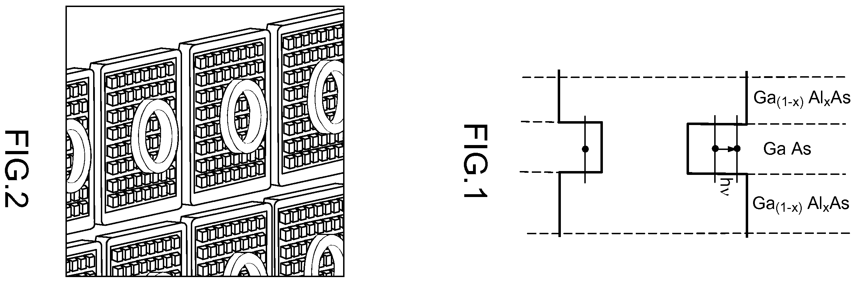

Les progrès rapides de la croissance par épitaxie sur substrat de type GaAs ont permis le développement d'une nouvelle classe de détecteurs d'ondes électromagnétiques utilisant l'absorption d'un rayonnement autour d'une longueur d'onde lambda, correspondant à la transition d'électrons entre différents niveaux d'énergie au sein d'une même bande d'énergie. Le schéma de la figure 1 illustre ce type de transition.

L'évolution récente des performances de ce type de composants est liée en particulier à la réalisation relativement facile de structures multicouches de semiconducteurs dans le système standard de l'épitaxie par jets moléculaires (MBE), c'est-à-dire le système GaAs/Ga₍₁₋ₓ₎AlₓAs. En ajustant les paramètres de croissance, l'épaisseur des puits quantiques et le pourcentage x en Aluminium dans les barrières imposant le potentiel de confinement, on peut choisir de centrer une bande étroite (environ 1 micron) de détection sur une longueur d'onde donnée. Un "micron" est un micromètre. Ce type de structure présente l'intérêt de fournir de très bonnes sensibilités en raison de la discrétisation des niveaux d'énergie au sein des bandes de conduction des matériaux photoconducteurs utilisés.

Ainsi les détecteurs à multi-puits quantiques se sont imposés comme une très bonne solution technique pour la réalisation de matrices sensibles au rayonnement infrarouge dans la bande 8-12 µm.

Dans le contexte des transitions intersousbandes, pour que ce type de transition soit possible il est nécessaire que le champ électrique de l'onde électromagnétique incidente ait une composante le long de la direction de croissance des couches, direction perpendiculaire au plan des couches. La conséquence de cet effet physique est qu'un détecteur présente peu d'absorption dans le cas d'une illumination à incidence normale.

Il a déjà été proposé d'utiliser des moyens de couplage de type réseau de diffraction (cf Goossen et Lyon, APL 47(1985), p1257-1259) pour générer ladite composante perpendiculaire en créant des rayonnements diffractés. On peut ainsi graver sur chaque pixel un réseau de diffraction fonctionnant en réflexion (les détecteurs sont éclairés en face arrière) comme décrit dans l'article "Grating-coupled quantum-well infrared detectors: Theory and performance", J. Y. Anderson and L. Lundqvist, J. Appl. Phys. 71, 3600 (1992) et illustré en figure 2 qui met en évidence l'utilisation de réseaux de plots permettant de coupler le rayonnement incident quelle que soit sa polarisation, au travers d'une vue réalisée par microscope électronique de pixels d'environ 20 microns de largeur, lesdits pixels comportant en surface des réseaux de diffraction, l'anneau supérieur n'étant qu'un élément de fixation sur une matrice de circuits de lecture sur silicium. Le document US 2004/0108564 A1 décrit un dispositif d'imagerie multispectrale comprenant une structure à multi-puits quantiques. Le document divulgue une matrice comprenant des sous-ensembles de quatre pixels, chaque pixel étant muni d'un réseau diffractif sensible à un sous-ensemble de longueurs d'onde centré sur une longueur d'onde donnée.

Le document EP 1 174 927 A2 décrit un dispositif d'auto-compensation pour un système d'imagerie avec une architecture soustractive.

L'ensemble constitué par la matrice de pixels réalisés au sein de la structure à multi-puits quantiques et par les réseaux de diffraction est dénommé ci-après plan focal.

Généralement, la structure à multi-puits quantiques permet d'élaborer des couches sensibles et donc des détecteurs dans des gammes de longueurs d'onde très étroites de l'ordre de 10% (soit une variation de longueurs d'onde Δλ/λ de l'ordre de 10 %)).

Ce type de structure active ne permet néanmoins pas d'élaborer des dispositifs d'imagerie susceptibles de fonctionner dans des spectres larges de longueurs d'onde malgré la très bonne sensibilité qu'ils permettent d'atteindre par ailleurs.

C'est pourquoi il est proposé dans la présente invention de remplacer la couche active standard, qui comporte généralement un empilement de couches semiconductrices permettant d'élaborer la structure à multi-puits quantiques sensible généralement dans une gamme de longueur d'onde très étroite et présentant typiquement une largeur de bande spectrale d'environ 10%, par une couche active large bande obtenue en alternant des puits quantiques différents. Il est ainsi possible de fabriquer des plans focaux multispectraux.

Plus précisément la présente invention a pour objet un dispositif d'imagerie multispectrale selon la revendication 1.

Les revendications dépendantes concernent d'autres variantes selon l'invention.

Selon une variante de l'invention, le quatrième pixel ne comporte pas de réseau diffractif.

Selon une variante de l'invention, le quatrième pixel comporte une structure de couplage optique non sélective en longueur d'onde.

Selon l'invention, le dispositif comporte des moyens de traitement des signaux récupérés au niveau des pixels élémentaires de détection.

Selon l'invention, les moyens de traitement des signaux comprennent des moyens de sommation des signaux issus respectivement des premier, second, troisième pixels élémentaires de détection et des moyens de soustraction du signal issu du quatrième pixel élémentaire de détection.

Selon une variante de l'invention, les premier, second et troisième réseaux de diffractions sont des réseaux à une dimension comportant des motifs lamellaires.

L'invention sera mieux comprise et d'autres avantages apparaîtront à la lecture de la description qui va suivre donnée à titre non limitatif et grâce aux figures annexées parmi lesquelles :
- la figure 1 illustre une structure à multi-puits quantiques selon l'art connu ;
- la figure 2 illustre une structure d'imageur comportant un réseau 2D ;
- les figures 3a et 3b illustrent respectivement les courbes d'absorption obtenues avec un plan focal comportant une structure à multi-puits quantiques sans réseau de diffraction sélectif et respectivement avec réseau de diffraction sélectif ;
- la figure 4 illustre un sous-ensemble Eij comportant quatre pixels élémentaires de détection ;
- la figure 5 illustre un exemple de plan focal utilisé dans un dispositif d'imagerie selon l'invention ;
- la figure 6 illustre une vue en coupe d'un plan focal selon l'invention tel que celui représenté en figure 5 ;
- la figure 7 illustre une structure de bande obtenue avec des puits quantiques et des barrières utilisés dans exemple d'empilement de couches d'un dispositif d'imagerie selon l'invention.

Le dispositif de l'invention est un dispositif d'imagerie comportant une structure absorbante dans une gamme de longueurs d'onde et comportant des ensembles élémentaires de réseaux diffractifs permettant de sélectionner une longueur d'onde donnée au niveau d'un pixel élémentaire donné grâce à un réseau diffractif et la sélection des différentes longueurs d'onde est obtenue en modifiant la période spatiale du réseau de couplage.

Le dispositif d'imagerie de l'invention comporte ainsi une architecture de plan focal compatible notamment avec l'imagerie à trois longueurs d'onde contenues dans une bande spectrale relativement étroite et optimisée du point de vue du recouvrement spectral comme décrit notamment dans l'article "Spectral cross-talk in dual-band quantum well infrared detectors", A. Nedelcu, X. Marcadet, O. Huet, P. Bois, Appl. Phys. Lett. 88, 191113 (2006).

L'invention peut être appliquée à tous les détecteurs à multi-puits quantiques, dans l'ensemble du spectre infrarouge 3-20 µm. Elle présente un intérêt maximum lorsque les trois longueurs d'onde détectées sont proches.

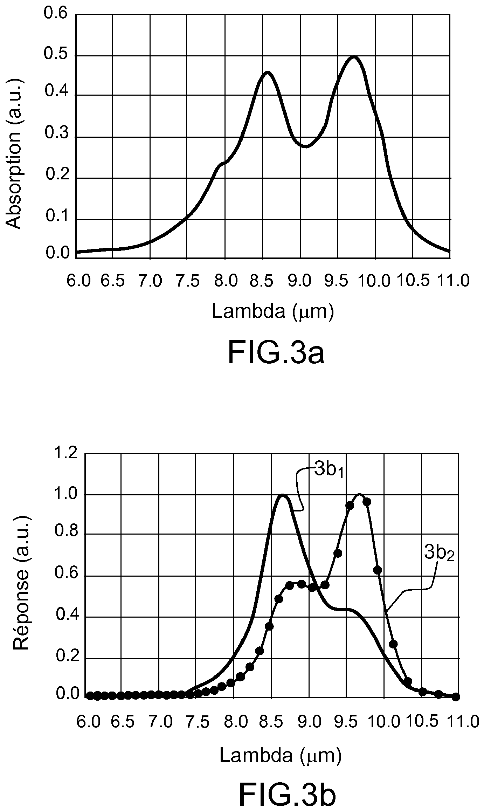

En remplaçant la couche active standard (largeur de bande spectrale 10%) par une couche active large bande (obtenue en alternant des puits quantiques différents), il est possible de fabriquer des plans focaux multispectraux. La sélection des différentes longueurs d'onde est obtenue en modifiant la période spatiale du réseau de couplage. Les figures 3a et 3b illustrent à ce titre respectivement l'absorption intrinsèque d'une structure multi-puits quantiques et celle obtenue en utilisant deux réseaux de périodes différentes.

Plus précisément, la figure 3b met en évidence par une courbe 3b₁ l'absorption obtenue avec un réseau 2D de période 2,7 microns et par une courbe 3b₂ l'absorption obtenue avec un réseau 2D de période 3 microns. La courbe 3b₁ montre une sensibilité accrue à 8,8 microns, la courbe 3b₂ mettant en évidence une sensibilité accrue à 9,8 microns.

De manière générale, le plan focal réalisé selon l'invention et utilisé dans un dispositif de l'invention comporte une structure à multi-puits quantiques couramment dénommés par l'acronyme « MPQ » comprenant un ensemble d'éléments de détection à la surface desquels sont réalisés des réseaux de diffraction sensibles sélectivement en longueur d'onde.

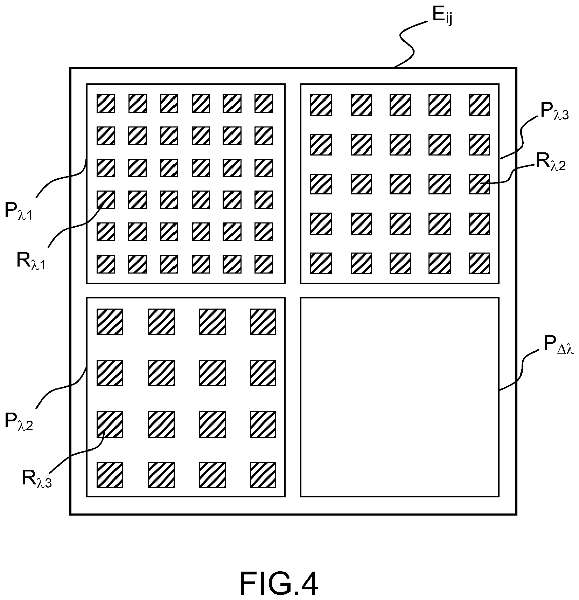

Plus précisément, cet ensemble comporte des sous-ensembles Eij constitués de quatre pixels élémentaires P_{λ1}, P_{λ2}, P_{λ3} et P_{Δλ} comportant respectivement chacun un premier réseau de diffraction R_{λ1} sensible dans un premier sous-ensemble de longueurs d'onde centré sur une première longueur d'onde λ₁, un second réseau de diffraction R_{λ2} sensible dans un second sous-ensemble de longueurs d'onde centré sur une première longueur d'onde λ₂, un troisième réseau de diffraction R_{λ3} sensible dans un premier sous-ensemble de longueurs d'onde centré sur une troisième longueur d'onde λ₃ et un pixel élémentaire P_{Δλ} large bande spectrale comme illustré en figure 4.

Les premier, second et troisième réseaux R_{λ1}, R_{λ2} et R_{λ3} comportent respectivement des pas de réseaux Λ₁, Λ₂ et Λ₃ différents.

Le quatrième pixel élémentaire de détection n'est pas muni de structure de couplage optique et présente une réponse large bande, due au couplage optique par les bords du pixel.

Pour conserver la résolution de l'image on utilise un système de micro-balayage. Quatre trames vidéo sont nécessaires pour construire quatre images contenant des informations spectrales différentes. La couche active est optimisée pour permettre un fonctionnement à haute cadence trame (200 Hz, temps d'intégration de 5 ms), ce qui autorise une cadence proche de 50 Hz après traitement, les paramètres d'optimisation étant notamment les taux de dopage des couches, les épaisseurs, le nombre de puits quantiques et les moyens de couplage optique.

Le dispositif d'imagerie multispectral comporte en outre des moyens de traitement du signal permettant de soustraire le signal du pixel élémentaire ne comportant pas de réseau diffractif en longueur d'onde. On parvient ainsi à soustraire typiquement la courbe de la figure 3a des courbes illustrées en figure 3b, permettant par la même de réduire le recouvrement spectral et d'augmenter le contraste entre les trois canaux relatifs aux informations récupérées au niveau respectivement des premier, second et troisième pixels élémentaires.

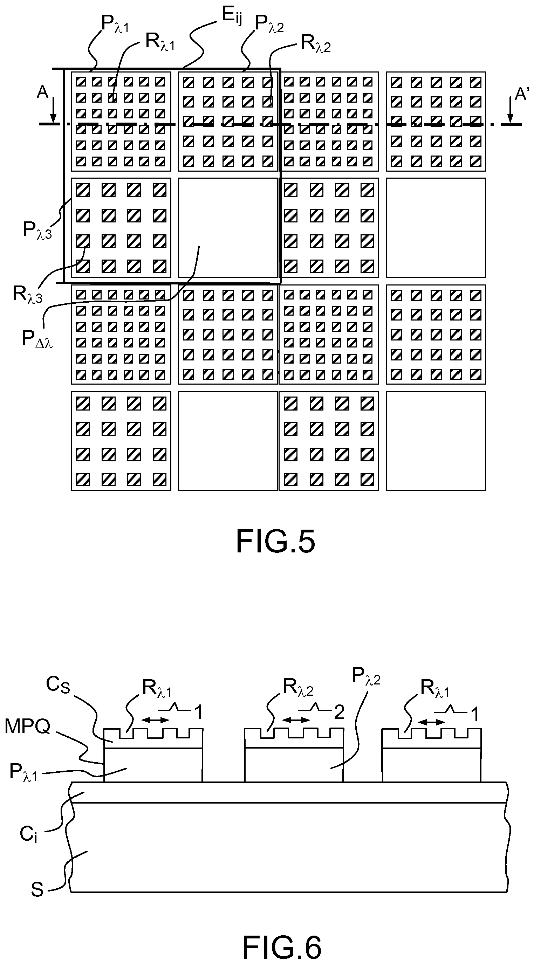

La figure 5 illustre ainsi une vue de dessus d'un plan focal selon l'invention comportant une matrice de sous-ensemble Eij.

De manière connue, le dispositif d'imagerie de l'invention peut être réalisé à la surface d'un substrat en matériau semiconducteur S. A la surface de ce matériau semiconducteur, on procède à un assemblage de couches constituant un contact ohmique dit inférieur Ci en matériau semiconducteur fortement dopé est déposé à la surface du substrat. Ce contact ohmique supporte l'ensemble des couches semiconductrices constitutives de la structure à multi-puits quantiques MPQ, celle-ci est en contact avec un assemblage de couches constituant un contact ohmique dit supérieur Cs, la détection étant assurée entre les deux contacts ohmiques. Avantageusement les réseaux diffractifs constitués de motifs périodiques peuvent être gravés dans la couche de contact ohmique comme illustré en figure 6 qui représente une vue en coupe selon l'axe AA' représenté en figure 5.

### Exemple de réalisation d'un dispositif d'imagerie selon l'invention

Nous allons décrire un exemple de dispositif d'imagerie fonctionnant dans un ensemble de longueurs d'onde comprises entre 8 µm et 11 µm selon l'invention, fonctionnant dans le domaine infrarouge et plus particulièrement adapté aux domaines 8-11 microns.

Le tableau ci-dessous décrit l'empilement de couches utilisé dans cet exemple de réalisation. Le facteur 10 indique que le motif décrit est répété 10 fois. L'empilement est décrit depuis le substrat jusqu'à la couche supérieure, les contacts ohmiques étant réalisés dans du GaAs dopé à hauteur de 10¹⁸ cm⁻³, le substrat étant en GaAs.

| | | | | |
|---|---|---|---|---|
| AlₓGa₁₋ₓAs | Barrière X_{Al} =26% | non dopé | 35 nm | X 10 |
| AlₓGa₁₋ₓAs | Puits X_{Al}=3% | dopé Si 2.10¹¹ cm⁻² | 5.5 nm | |
| AlₓGa₁₋ₓAs | Barrière X_{Al} =26% | non dopé | 35 nm | |
| GaAs | Puits | dopé Si 2. 10¹¹ cm⁻² | 5 nm | |
| AlₓGa₁₋ₓAs | Barrière X_{Al} =26% | non dopé | 35 nm | |

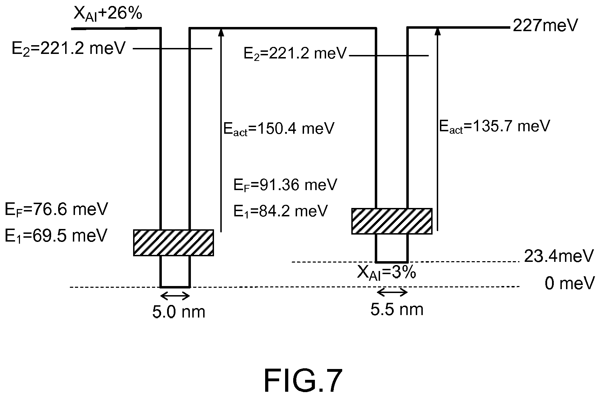

La structure de bande obtenue avec ces exemples de puits quantiques et de barrières, associée à une période (2 puits) est illustrée en figure 7 qui montre les niveaux d'énergie intersousbandes et ce pour un taux x dans l'alliage AlₓGa₁₋ₓAs égal à 0,26.

## Revendications

1. Dispositif d'imagerie multispectrale comprenant une structure à multi-puits quantiques comprenant une matrice de pixels élémentaires de détection fonctionnant sur des transitions intersousbandes par absorption d'un rayonnement à une longueur d'onde lambda comprise dans un ensemble de longueurs d'ondes auxquelles est sensible ladite structure, ladite matrice de pixels élémentaires de détection étant destinée à être éclairée par ledit rayonnement, chaque pixel élémentaire de détection comprenant un plot distinct (C_{S}, MPQ) à formé d'un empilement de couches semiconductrices (MPQ) réalisé à la surface d'un substrat (S) et constitutif de la structure à multi-puits quantiques, la matrice étant organisée en sous-ensembles de quatre pixels élémentaires de détection (Eij), chacun desdits sous-ensembles comprenant:
- un premier pixel élémentaire de détection (P_{λ1}) comportant un premier réseau diffractif (R_{λ1}) disposé à la surface du plot du premier pixel, le premier réseau étant sensible à un unique premier sous-ensemble de longueurs d'onde centré sur une première longueur d'onde (λ₁) ;
- un second pixel élémentaire de détection (P_{λ2}) comportant un second réseau diffractif (R_{λ2}) disposé à la surface du plot du second pixel, le second réseau étant sensible à un unique second sous-ensemble de longueurs d'onde centré sur une seconde longueur d'onde (λ₂);
- un troisième pixel élémentaire de détection (P_{λ3}) comportant un troisième réseau diffractif (R_{λ3}) disposé à la surface du plot du troisième pixel, le troisième réseau étant sensible à un unique troisième sous-ensemble de longueur d'ondes centré sur une troisième longueur d'onde (λ₃) ;
les première, deuxième et troisième longueurs d'onde étant des longueurs d'onde différentes ;
**caractérisé en ce que** chacun desdits sous-ensembles comprend:
- un quatrième pixel élémentaire de détection (P_{Δλ}) ne comportant pas de réseau diffractif sélectif en longueur d'onde disposé sur le plot du quatrième pixel ;
**en ce que** les premier, second et troisième sous-ensembles de longueurs d'onde appartiennent à l'ensemble de longueurs d'onde auquel est sensible ladite structure ; et **en ce que** le dispositif comporte des moyens de traitement des signaux récupérés au niveau des pixels élémentaires de détection, les moyens de traitement des signaux comprenant des moyens de sommation des signaux issus respectivement des premier, second, troisième pixels élémentaires de détection et des moyens de soustraction du signal issu du quatrième pixel élémentaire de détection.

2. Dispositif d'imagerie multispectrale selon la revendication 1, ***caractérisé* en ce que** le quatrième pixel élémentaire de détection ne comporte pas de réseau diffractif

3. Dispositif d'imagerie multispectrale selon la revendication 1, ***caractérisé* en ce que** le quatrième pixel élémentaire de détection comporte une structure de couplage optique non sélective en longueur d'onde.

4. Dispositif d'imagerie multispectrale selon l'une des revendications 1 à 3, ***caractérisé* en ce que** les premier, second et troisième réseaux de diffractions sont des réseaux à une dimension comportant des motifs lamellaires.

5. Dispositif d'imagerie multispectrale selon la revendications 4, ***caractérisé* en ce que** ledit empilement comprend un contact ohmique disposé sur chacun des plots de la matrice de plots, des motifs périodiques étant gravés au sein dudit contact ohmique de manière à réaliser les différents réseaux.

6. Dispositif d'imagerie multispectrale selon l'une des revendications 1 à 5, ***caractérisé* en ce que** l'empilement des couches semiconductrices (MPQ) est un empilement de couches de type GaAs ou InGaAs dopé constituant les puits, de couches de type AlGaAs ou InAlAs non dopé constituant les barrières, le substrat étant de type GaAs ou InP non dopé.

7. Dispositif d'imagerie multispectrale selon la revendication 6, ***caractérisé* en ce que** ledit empilement de couches semi-conductrices est composé d'un empilement de couches de GaAs dopé et de couches de GaAlAs non dopé formé sur une couche de de contact ohmique (Cᵢ) à base de GaAs plus fortement dopée que les couches de l'empilement constitutives de la structure à multi-puits quantiques.

8. Dispositif d'imagerie multispectrale selon l'une des revendications 6 et 7, **caractérisé en ce qu'**il comprend un substrat transparent à la longueur d'onde du rayonnement incident et une couche réflectrice à ladite longueur d'onde, ladite couche réflectrice étant à la surface des réseaux de diffraction, de manière à faire fonctionner le détecteur en réflexion.

9. Dispositif d'imagerie multispectrale selon l'une des revendications 1 à 8 , ***caractérisé* en ce qu'**il comporte en outre des moyens de micro-balayage permettant d'effectuer une série d'images contenant des informations spectrales différentes.

10. Dispositif d'imagerie multispectrale selon l'une quelconque des revendications précédentes, ***caractérisé* en ce que** la matrice de pixels élémentaires de détection comprend :
- le substrat (S) en matériau semi-conducteur ;
- une couche (Cᵢ) formant un premier contact ohmique en matériau semi-conducteur fortement dopé, déposée sur le substrat ;
- la matrice de plots disposées sur la couche formant ledit contact ohmique ; et
- un second contact ohmique (C_{S}) disposé sur chacun des plots de la matrice de plots.

## Patentansprüche

1. Multispektrale Bildgebungsvorrichtung, umfassend eine Quantentopfstruktur mit einer Elementarpixel- Erkennungsmatrix
funktionierend mit Inter- Subband- Übergängen zur Absorption einer Strahlung mit einer Lambda-Wellenlänge in einer Gesamtheit von Wellenlängen, gegenüber denen diese Struktur empfindlich ist, diese Elementarpixel- Erkennungsmatrix ist dazu bestimmt, von dieser Strahlung beleuchtet zu werden, jedes elementare Erkennungspixel umfasst einen bestimmten Plot (C_{S}MPQ),
gebildet aus einem Stapel von Halbleiterschichten (MPQ), ausgeführt auf der Oberfläche eines Substrats (S) und die Quantentopfstruktur bildend, dabei ist die Matrix in Sub- Einheiten auf vier elementaren Erkennungspixel (Eij) organisiert, wobei jede dieser Sub- Einheiten umfasst:
- ein erstes elementares Erkennungspixel (P_{λ1}) mit einem ersten diffraktiven Gitter (R_{λ1}), angeordnet auf der Oberfläche des Plots des ersten Pixels, das erste Gitter ist nur empfindlich gegenüber einer einzigen Wellenlängen-Subeinheit, zentriert auf eine erste Wellenlänge (λ₁);
- ein zweites elementares Erkennungspixel (P_{λ2}) mit einem zweiten diffraktiven Gitter (R_{λ2}), angeordnet auf der Oberfläche des Plots des zweiten Pixels, das zweite Gitter ist nur empfindlich gegenüber einer einzigen Wellenlängen- Subeinheit, zentriert auf eine zweite Wellenlänge (λ₂);
- ein drittes elementares Erkennungspixel (P_{λ3}) mit einem dritten diffraktiven Gitter (R_{λ3}), angeordnet auf der Oberfläche des Plots des dritten Pixels, das dritte Gitter ist nur empfindlich gegenüber einer einzigen Wellenlängen-Subeinheit, zentriert auf eine dritte Wellenlänge λ₃);
die erste, zweite und dritte Wellenlänge sind unterschiedliche Wellenlängen; **dadurch gekennzeichnet, dass** jede dieser Untereinheiten umfasst:
- ein viertes elementares Erkennungspixel (P_{Δλ}), das kein nach Wellenlängen selektives, diffraktives Gitter, angeordnet auf dem Plot des vierten Pixels umfasst;
dadurch dass die erste, zweite und dritte Wellenlängen- Untereinheiten zu einer Wellenlängeneinheit gehören, gegenüber der diese Struktur empfindlich ist; und dass die Vorrichtung Mittel zur Signalbearbeitung umfasst, die an den elementaren Erkennungspixeln aufgefangen wurden, die Mittel zur Signalbearbeitung umfassen Mittel zur Summierung der Signale, die jeweils aus den ersten, zweiten und dritten elementaren Erkennungspixeln hervorgegangen sind, und Mittel zur Subtraktion des Signals, hervorgegangen aus dem vierten elementaren Erkennungspixel.

2. Multispektrale Bildgebungsvorrichtung, nach Anspruch 1, ***dadurch gekennzeichnet, dass*** das vierte elementare Erkennungspixel kein diffraktives Gitter enthält.

3. Multispektrale Bildgebungsvorrichtung, nach Anspruch 1, ***dadurch gekennzeichnet, dass*** das vierte elementare Erkennungspixel eine nicht nach Wellenlängen selektive, optische Kopplungsstruktur enthält.

4. Multispektrale Bildgebungsvorrichtung, nach einem der Ansprüche 1 bis 3, ***dadurch gekennzeichnet, dass*** das erste, zweite und dritte Diffraktionsgitter eindimensionale Gitter sind, die lamellenförmige Muster enthalten.

5. Multispektrale Bildgebungsvorrichtung, nach Anspruch 4, ***dadurch gekennzeichnet, dass*** dieser Stapel einen ohmschen Kontakt umfasst, der auf jedem Plot der Plotmatrix angeordnet ist, in diesem ohmschen Kontakt sind regelmäßig wiederkehrende Muster eingraviert, so dass verschiedene Gitter ausgeführt werden.

6. Multispektrale Bildgebungsvorrichtung, nach einem der Ansprüche 1 bis 5, ***dadurch gekennzeichnet, dass*** der Stapel Halbleiterschichten (MPQ) ein Stapel Schichten vom Typ GaAs oder dotiertem InGaAs ist, die die Töpfe bilden, Schichten vom Typ AlGaAs oder nicht dotiertem InAlAs, die die Barrieren bilden, das Substrat ist vom Typ GaAs oder nicht dotiertem InP.

7. Multispektrale Bildgebungsvorrichtung, nach Anspruch 6, **dadurch gekennzeichnet, dass** dieser Stapel Halbleiterschichten aus einem Stapel dotierter GaAs- Schichten und nicht dotierter GaAIAs - Schichten besteht, gebildet auf einer Schicht, gebildet auf einer ohmschen Kontaktschicht (C_{¡}) auf Basis von GaAs, das stärker dotiert ist als die die Schichten des Stapels, die die Quantentopfstruktur bilden.

8. Multispektrale Bildgebungsvorrichtung, nach einem der Ansprüche 6 und 7, ***dadurch gekennzeichnet, dass*** sie ein gegenüber der einfallenden Strahlungswellenlänge durchlässiges Substrat umfasst und eine Reflektionsschicht dieser Wellenlänge, diese Reflektionsschicht befindet sich auf der Oberfläche der Diffraktionsgitter, so dass der Detektor bei Reflexion arbeitet.

9. Multispektrale Bildgebungsvorrichtung, nach einem der Ansprüche 1 und 8, ***dadurch gekennzeichnet, dass*** sie außerdem Mittel zur Mikroabtastung enthält, mit der eine Bilderserien erstellt werden kann, die unterschiedliche Spektralinformationen enthält.

10. Multispektrale Bildgebungsvorrichtung, nach irgendeinem der vorangehenden Ansprüche, ***dadurch gekennzeichnet, dass*** die Elementarpixel- Erkennungsmatrix umfasst:
- das Substrat (S) aus Halbleitermaterial
- eine Schicht (C_{¡}), die einen ersten ohmschen Kontakt, aus stark dotiertem Halbleitermaterial bildet, abgeschieden auf dem Substrat;
- die Plotmatrix, angeordnet auf der Schicht, die diesen ohmschen Kontakt bildet; und
- ein zweiter ohmscher Kontakt (C_{S}), angeordnet auf jedem einzelnen Plot der Plotmatrix.

## Claims

1. Multispectral imaging device incorporating a quantic multi-well structure that incorporates a matrix of elementary detection pixels operating on inter-sub-band transitions, by absorption of radiation at a wavelength λ lying within a set of wavelengths to which said structure is sensitive, with the elementary detection pixel matrix being designed to be illuminated by the said radiation, with each elementary detection pixel incorporating a separate said structure incorporating a matrix of individual detection pixels incorporating a separate stud (CSMPQ) composed of a stack of semiconducting layers (MPQ) produced on the surface of a substrate (S) and constituting the quantic multi-well structure, with the matrix being organized into subsets of four elementary detection pixels (Eij), with each of the said subsets incorporating:
- a first elementary detection pixel (Pλ1) incorporating a first diffraction grating (Rλ1) positioned on the surface of the stud of the first pixel, with the first grating being sensitive to a unique first subset of wavelengths centered on a first wavelength (λ1);
- a second elementary detection pixel (Pλ2) incorporating a second diffraction grating (Rλ2) positioned on the surface of the stud of the second pixel, with the second grating being sensitive to a unique second subset of wavelengths centered on a second wavelength (λ2);
- a third elementary detection pixel (Pλ3) positioned on the surface of the stud of the third pixel, with the third grating being sensitive to a unique third subset of wavelengths centered on a third wavelength (λ3);
with the first, second and third wavelengths being different wavelengths; **characterized in that** each of the said subsets incorporates:
- a fourth individual detection pixel (PΔλ) not incorporating a wavelength-selective diffraction grating positioned on the stud of the fourth pixel;
**characterized in that** the first, second and third subsets of wavelengths belong to the set of wavelengths to which the said structure is sensitive; and **in that** the device incorporates a system for processing signals recovered at the elementary detection pixels, with the signal processing system incorporating a system of summing signals from, respectively, the first, second and third elementary detection pixels and a system for subtraction of the signal emitted by the fourth elementary detection pixel.

2. Multispectral imaging device in accordance with claim 1, **characterized in that** the fourth individual detection pixel does not incorporate a diffraction grating.

3. Multispectral imaging device in accordance with claim 1, **characterized in that** the fourth elementary detection pixel incorporates a non-wavelength-selective optical coupling structure.

4. Multispectral imaging device in accordance with one of claims 1 to 3, **characterized in that** the first, second and third diffractive gratings are one-dimensional gratings incorporating lamellar patterns.

5. Multispectral imaging device in accordance with claim 4, **characterized in that** the said stack incorporates an ohmic contact positioned on each of the studs of the stud matrix, with periodic patterns being etched into the said ohmic contact in order to produce the different gratings.

6. Multispectral imaging device in accordance with one of claims 1 to 5, **characterized in that** the semiconductor layer stack (MPQ) is a stack of doped layers of GaAs type or InGaAs type constituting the wells, and layers of undoped AlGaAs or InAlAs type constituting barriers, with the substrate being of undoped InP or GaAs type.

7. Multispectral imaging device in accordance with claim 6, **characterized in that** the said semiconductor layer stack is composed of a stack of doped GaAs layers and undoped GaAlAs layers formed on an ohmic contact layer (C1) produced from GaAs more-strongly doped that the layers of the stack constituting the quantic multi-well structure.

8. Multispectral imaging device in accordance with one of claims 6 and 7, **characterized in that** it incorporates a substrate transparent to the wavelength of the incident radiation, and a layer reflective to the said wavelength, with the said reflective layer being on the surface of the diffractive gratings, such as to cause the detector to operate in reflection.

9. Multispectral imaging device in accordance with one of claims 1 to 8, **characterized in that** it also incorporates a micro-scanning system allowing the production of a series of images containing different spectral information.

10. Multispectral device in accordance with any one of the preceding claims, **characterized in that** the matrix of elementary detection pixels incorporates:
- the substrate (S) in semiconductor material;
- a layer (C1) forming a highly-doped first ohmic contact in semiconductor material deposited on the substrate;
- the matrix of studs deposited on the layer forming the said ohmic contact; and
- a second ohmic contact (CS) deposited on each of the studs of the stud matrix.
